# EUROPEAN PATENT SPECIFICATION

(11) **EP 3 312 880 B1**
(45) Date of publication and mention of the grant of the patent: **07.04.2021**
(21) Application number: 17198017.0
(22) Date of filing: 24.10.2017
(51) Int. Cl.: H01L 23/498, H01L 23/66

(54) **PACKAGE SUBSTRATE AND FABRICATION METHOD THEREOF, AND INTEGRATED CIRCUIT CHIP**
VERPACKUNGSSUBSTRAT UND HERSTELLUNGSVERFAHREN DAFÜR UND CHIP MIT INTEGRIERTER SCHALTUNG
SUBSTRAT DE BOÎTIER ET SON PROCÉDÉ DE FABRICATION ET PUCE DE CIRCUIT INTÉGRÉ

(30) Priority: 24.10.2016 CN 201610937783
(43) Date of publication of application: 25.04.2018
(73) Proprietor: HUAWEI TECHNOLOGIES CO., LTD., Shenzhen, Guangdong 518129 (CN)
(72) Inventor: FU, HuiLi, Shenzhen Guangdong 518129 (CN); GUO, Jianwei, Shenzhen Guangdong 518129 (CN); LIU, Tiejun, Shenzhen Guangdong 518129 (CN)
(74) Representative: Thun, Clemens

(56) References cited:
- WO-A1-2015/171118
- US-B1- 6 353 189

## Description

### TECHNICAL FIELD

The present invention relates to the field of communications technologies, and in particular, to a package substrate and a fabrication method thereof, and an integrated circuit chip.

### BACKGROUND

A package substrate is a motherboard for manufacturing an integrated circuit (IC) chip or a printed circuit board (PCB).

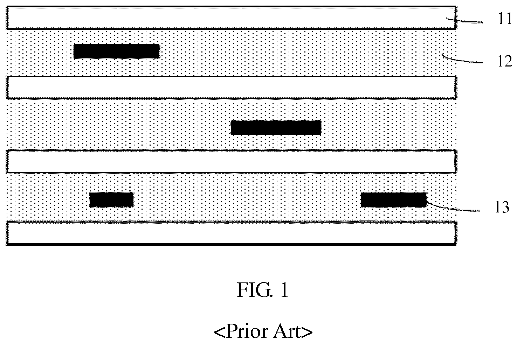

As shown in FIG. 1, the package substrate is formed by a conductive reference layer 11 and a non-conductive dielectric layer 12 that are stacked alternately. A signal circuit is laminated inside the dielectric layer 12. The signal circuit is generally formed by one or more metal traces 13. The reference layer 11 is generally configured to carry a power supply or ground signal. A signal carried in each metal trace 13 is eventually led to each input/output (I/O) interface of the IC chip or the PCB.

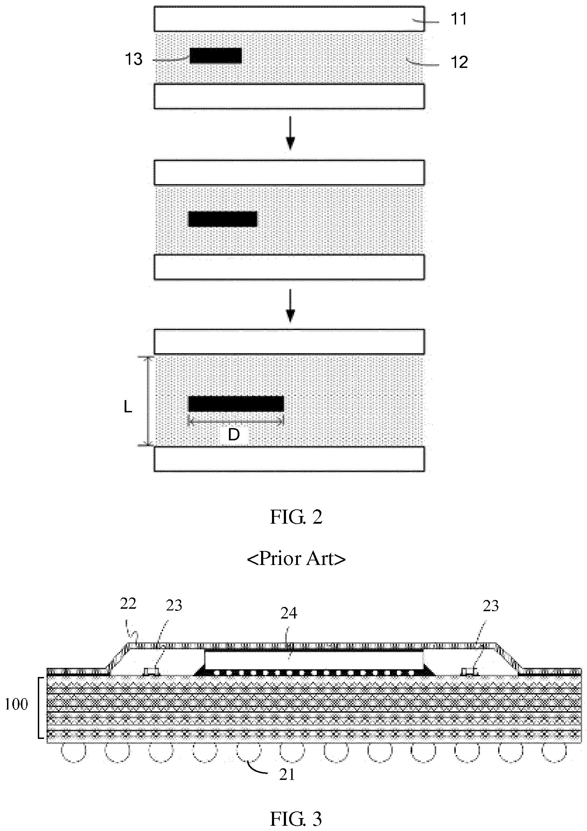

However, a higher speed or frequency of a signal brings severer attenuation of the signal being transmitted on the metal trace 13, and causes a larger link loss. Generally, the link loss can be reduced by increasing a width of the metal trace 13, but a change in the trace width causes a change in impedance of the metal trace 13. To ensure that the impedance remains unchanged, a thickness of the dielectric layer 12 needs to be designed according to a signal speed. As shown in FIG. 2, one dielectric layer 12 is used as an example. When the signal speed is higher, a width D of the metal trace 13 is larger, and a thickness L of the dielectric layer 12 is also larger.

However, because a mechanical property of a material for fabricating the dielectric layer 12 is relatively poor, it is difficult to produce a dielectric layer 12 with a large thickness. When the thickness L of the dielectric layer 12 is increased to an extent, a technique process limit is reached. In this case, the thickness of the dielectric layer 12 cannot be further increased, and the link loss cannot be reduced.

A PCT application, numbered as WO 2015/171118, provides a multi-layer package with integrated antenna.

### SUMMARY

Embodiments of the present invention provide a package substrate and a fabrication method thereof, and an integrated circuit chip, so as to reduce a link loss generated when a high frequency signal or a high-speed signal is being transmitted in the package substrate.

To achieve the foregoing objective, the following technical solutions are used in the embodiments of the present invention:
According to a first aspect, an embodiment of the present invention provides a package substrate, including a first reference layer and a second reference layer that are disposed opposite to each other, a first composite layer is disposed on a side that is of the first reference layer and close to the second reference layer, a second composite layer is disposed on a side that is of the second reference layer and close to the first reference layer, and a metal trace is laminated between the first composite layer and the second composite layer; and the first composite layer and the second composite layer each include a first dielectric layer and a second dielectric layer that are disposed opposite to and in contact with each other, the first dielectric layer is in contact with the metal trace, and stiffness of the second dielectric layer is greater than stiffness of the first dielectric layer, wherein a dielectric loss factor of the first dielectric layer is less than a dielectric loss factor of the second dielectric layer. That is, different from a conventional arrangement of a single dielectric layer enclosing a metal trace, in the package substrate provided in the embodiments of the present invention, the metal trace is laminated between the first composite layer and the second composite layer, and each composite layer includes the first dielectric layer and the second dielectric layer that are respectively made of two types of dielectrics. In both composite layers, the first dielectric layer with relatively small stiffness is in contact with the metal trace, so that the metal trace is enclosed by the first dielectric layers by using a lamination technique. The second dielectric layer with relatively large stiffness is disposed on a side that is of the first dielectric layer and away from the metal trace. The second dielectric layer has relatively large stiffness and is not easy to deform. Therefore, a second dielectric layer with a relatively large thickness can be produced. In this case, for a high frequency signal or a high-speed signal, a conductor loss generated during signal transmission may be reduced by increasing a thickness of the second dielectric layer in addition to increasing a width of the metal trace, thereby reducing a link loss throughout the transmission.

The smaller dielectric loss factor of a dielectric layer results in a smaller dielectric loss generated when a signal is being transmitted at the dielectric layer. In this case, when the dielectric loss factor of the first dielectric layer is less than the dielectric loss factor of the second dielectric layer, a dielectric loss generated when a signal on the metal trace is being transmitted at the first dielectric layer can be reduced because the metal trace is enclosed by the first dielectric layer in the first composite layer and the first dielectric layer in the second composite layer. That is, the package substrate provided in the embodiments of the present invention can not only reduce the conductor loss generated during signal transmission, but also reduce the dielectric loss generated during signal transmission.

In a possible design manner, the first composite layer and the second composite layer each further include: a third dielectric layer disposed on a side that is of the second dielectric layer and away from the first dielectric layer, where a mechanical property of a material of the third dielectric layer is the same as a mechanical property of a material of the first dielectric layer.

In a possible design manner, the material of the third dielectric layer is the same as the material of the first dielectric layer, and a thickness of the third dielectric layer is equal to a thickness of the first dielectric layer. In this case, the first composite layer and the second composite layer each can be regarded as a "sandwich structure" in which the first dielectric layer and the third dielectric layer sandwich the second dielectric layer. In the "sandwich structure", when the first dielectric layer and the third dielectric layer with the same material are respectively disposed on two sides of the second dielectric layer for lamination, tension is generated on both a contact surface between the first dielectric layer and the second dielectric layer and a contact surface between the third dielectric layer and the second dielectric layer. In this way, the first dielectric layer and the third dielectric layer are attached on the two sides of the second dielectric layer, so that a structurally stable "sandwich structure" is formed in each of the first composite layer and the second composite layer. Therefore, more stable structures of the first composite layer and the second composite layer are formed.

In a possible design manner, a coefficient of thermal expansion of the second dielectric layer is less than or equal to 9 ppm/°C.

In a possible design manner, a Young's modulus of the second dielectric layer is greater than or equal to 25 MPa.

In a possible design manner, a dielectric loss factor of the first dielectric layer is less than or equal to 0.01.

According to a second aspect, an embodiment of the present invention provides a method for fabricating a package substrate, including: laminating a first composite layer on a first reference layer, where the first composite layer includes a first dielectric layer and a second dielectric layer that are disposed opposite to each other, stiffness of the second dielectric layer is greater than stiffness of the first dielectric layer, and the first dielectric layer in the first composite layer is away from the first reference layer; forming a metal trace at the first composite layer; laminating a second composite layer on the first composite layer at which the metal trace is formed, where the second composite layer includes a first dielectric layer and a second dielectric layer that are disposed opposite to each other, stiffness of the second dielectric layer is greater than stiffness of the first dielectric layer, and the first dielectric layer in the second composite layer is in contact with the metal trace, wherein a dielectric loss factor of the first dielectric layer is less than a dielectric loss factor of the second dielectric layer; and laminating a second reference layer on the second composite layer.

In a possible design manner, before the laminating a first composite layer on a first reference layer, the method further includes: fabricating the first composite layer and the second composite layer.

In a possible design manner, the first composite layer and the second composite layer each further include: a third dielectric layer disposed on a side that is of the second dielectric layer and away from the first dielectric layer, and a material of the third dielectric layer is the same as a material of the first dielectric layer, where fabricating the first composite layer or the second composite layer includes: respectively laminating the first dielectric layer and the third dielectric layer onto two sides of the second dielectric layer to obtain the first composite layer or the second composite layer.

In a possible design manner, the laminating a first composite layer on a first reference layer includes: laminating the first composite layer onto the first reference layer by using the third dielectric layer in the first composite layer as a lamination surface; and the laminating a second composite layer on the first composite layer at which the metal trace is formed includes: laminating, by using the first dielectric layer in the second composite layer as a lamination surface, the second composite layer onto the first composite layer at which the metal trace is formed.

According to a third aspect, an embodiment of the present invention provides an integrated circuit chip, and the integrated circuit chip includes the package substrate.

In the present invention, a name of the package substrate does not set a limitation on devices themselves. In actual implementation, these devices may appear with other names. Provided that their functions are similar to those in the present invention, the various devices fall within the scope of the claims of the present invention and the equivalents thereof.

In addition, for a technical effect brought by any one of the design manners in the second aspect to the fifth aspect, refer to the technical effect brought by the different design manners in the first aspect. Details are not provided herein.

These aspects or other aspects of the present invention are more readily understood in following descriptions of embodiments.

### BRIEF DESCRIPTION OF DRAWINGS

To describe the technical solutions in the embodiments of the present invention or in the prior art more clearly, the following briefly describes the accompanying drawings required for describing the embodiments or the prior art.
FIG. 1 is a schematic structural diagram of a package substrate in the prior art;
FIG. 2 is a schematic diagram of a principle of reducing a link loss in the prior art;
FIG. 3 is a schematic diagram of an application scenario of a package substrate according to an embodiment of the present invention;
FIG. 4 is schematic structural diagram 1 of a package substrate according to an embodiment of the present invention;
FIG. 5 is schematic structural diagram 2 of a package substrate according to an embodiment of the present invention;
FIG. 6 is a schematic flowchart of a method for fabricating a package substrate according to an embodiment of the present invention;
FIG. 7 is schematic diagram 1 of a technique of a method for fabricating a package substrate according to an embodiment of the present invention;
FIG. 8 is schematic diagram 2 of a technique of a method for fabricating a package substrate according to an embodiment of the present invention; and
FIG. 9 is schematic diagram 3 of a technique of a method for fabricating a package substrate according to an embodiment of the present invention.

### DESCRIPTION OF EMBODIMENTS

The following describes the technical solutions in the embodiments of the present invention with reference to the accompanying drawings in the embodiments of the present invention. Apparently, the described embodiments are merely a part rather than all of the embodiments of the present invention.

In addition, the terms "first" and "second" are merely intended for a purpose of description, and shall not be understood as an indication or implication of relative importance or implicit indication of the number of indicated technical features. Therefore, a feature limited by "first" or "second" may explicitly or implicitly include one or more features. In the description of the present invention, "multiple" means two or more unless otherwise specified.

An embodiment of the present invention provides a package substrate, and the package substrate may be used as a motherboard in a structure such as an IC chip or a PCB.

For example, as shown in FIG. 3, FIG. 3 is a cross sectional view of an IC chip. Solder balls 21 are disposed on one side of a package substrate 100. The solder balls 21 may be used as an I/O interface of the IC chip for communication with an external device. A package surface 22 is disposed on the other side of the package substrate 100. A passive component 23 and a wafer 24 may be packaged under the package surface 22.

As shown in FIG. 1, a conventional package substrate 100 is formed by a conductive reference layer 11 and a non-conductive dielectric layer 12 that are stacked alternately. In an IC chip, a signal is generally transmitted on a metal trace 13 in the dielectric layer 12. A higher speed or frequency of the signal brings severer attenuation of the signal being transmitted on the metal trace 13. Such a loss caused by the metal trace 13 is referred to as a conductor loss (conductor loss). In addition, the dielectric layer 12 is made of a non-conductive insulating material. In this case, when the signal is being transmitted on the metal trace 13, the insulating material causes an energy loss inside the dielectric layer 12 due to a hysteresis effect of dielectric conductivity and dielectric polarization under the influence of an electric field. Such a loss caused by the dielectric layer 12 in which the metal trace 13 is located is referred to as a dielectric loss (dielectric loss).

That is, a link loss generated when a signal is being transmitted in the package substrate 100 includes a conductor loss and a dielectric loss. A width of the metal trace 13 is inversely proportional to resistance of the metal trace 13. Therefore, the conductor loss is usually reduced by increasing the width of the metal trace 13. However, after the width of the metal trace 13 is increased, impedance of the metal trace 13 is changed accordingly. Therefore, in addition to the width of the metal trace 13, a thickness of the dielectric layer 12 also needs to be increased, so as to ensure that impedance is consistent before and after the width of the metal trace 13 is changed. The dielectric layer 12 is generally made of a material with relatively good flexibility and is easy to deform during production. Therefore, a dielectric layer 12 with a relatively large thickness cannot be obtained, and an indicator requirement of the link loss generated when a high frequency signal or a high-speed signal is being transmitted in the package substrate 100 cannot be met.

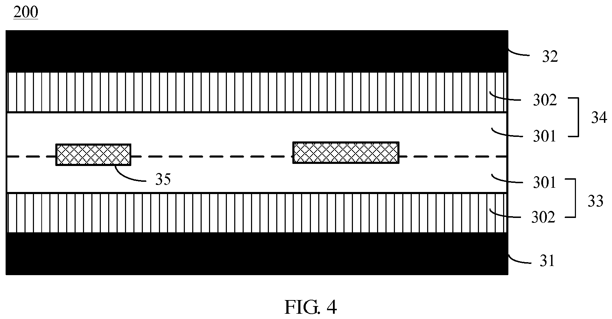

In view of this, an embodiment of the present invention provides a package substrate 200. As shown in FIG. 4, the package substrate 200 includes a first reference layer 31 and a second reference layer 32 that are disposed opposite to each other. A first composite layer 33 is disposed on a side that is of the first reference layer 31 and close to the second reference layer 32, a second composite layer 34 is disposed on a side that is of the second reference layer 32 and close to the first reference layer 31, and a metal trace 35 is laminated between the first composite layer 33 and the second composite layer 34.

Still as shown in FIG. 4, the first composite layer 33 and the second composite layer 34 each include a first dielectric layer 301 and a second dielectric layer 302 that are disposed opposite to each other, the first dielectric layer 301 is in contact with the second dielectric layer 302, the first dielectric layer 301 is in contact with the metal trace 35, and stiffness of the second dielectric layer 302 is greater than stiffness of the first dielectric layer 301.

That is, different from a conventional arrangement of a single dielectric layer enclosing the metal trace 35, in the package substrate 200 provided in this embodiment of the present invention, the metal trace 35 is laminated between the first composite layer 33 and the second composite layer 34, and each composite layer includes the first dielectric layer 301 and the second dielectric layer 302 that are respectively made of two types of dielectrics. In both composite layers, the first dielectric layer 301 with relatively small stiffness is in contact with the metal trace 35, so that the metal trace 35 is enclosed by the first dielectric layers 301 by using a lamination technique. The second dielectric layer 302 with relatively large stiffness is disposed on a side that is of the first dielectric layer 301 and away from the metal trace 35. The second dielectric layer 302 has relatively large stiffness and is not easy to deform. Therefore, a second dielectric layer with a relatively large thickness can be produced. In this case, for a high frequency signal or a high-speed signal, a conductor loss generated during signal transmission may be reduced by increasing a thickness of the second dielectric layer 302 in addition to increasing a width of the metal trace 35. This also ensures that impedance is consistent before and after the width of the metal trace 35 is changed, thereby reducing a link loss throughout the transmission.

Further, a dielectric loss factor of the first dielectric layer 301 is less than a dielectric loss factor of the second dielectric layer 302.

The dielectric loss factor may also be referred to as a dielectric loss tangent (Dielectric Loss Tangent, Df). The dielectric loss tangent is a complementary angle δ of an included angle (that is, a power vector angle Φ) between a current vector and a voltage vector passing through a dielectric under an alternating electric field, and can reflect a phase difference of electric displacement and electric field strength of the dielectric under the influence of the alternating electric field.

A smaller dielectric loss factor of a dielectric layer results in a smaller dielectric loss generated when a signal is being transmitted at the dielectric layer. In this case, in the package substrate 200 provided in this embodiment of the present invention, as shown in FIG. 4, when the dielectric loss factor of the first dielectric layer 301 is less than the dielectric loss factor of the second dielectric layer 302, a dielectric loss generated when a signal on the metal trace 35 is being transmitted at the first dielectric layer 301 can be reduced because the metal trace 35 is enclosed by the first dielectric layer 301 in the first composite layer 33 and the first dielectric layer 301 in the second composite layer 34. That is, the package substrate 200 provided in this embodiment of the present invention can not only reduce the conductor loss generated during signal transmission, but also reduce the dielectric loss generated during signal transmission.

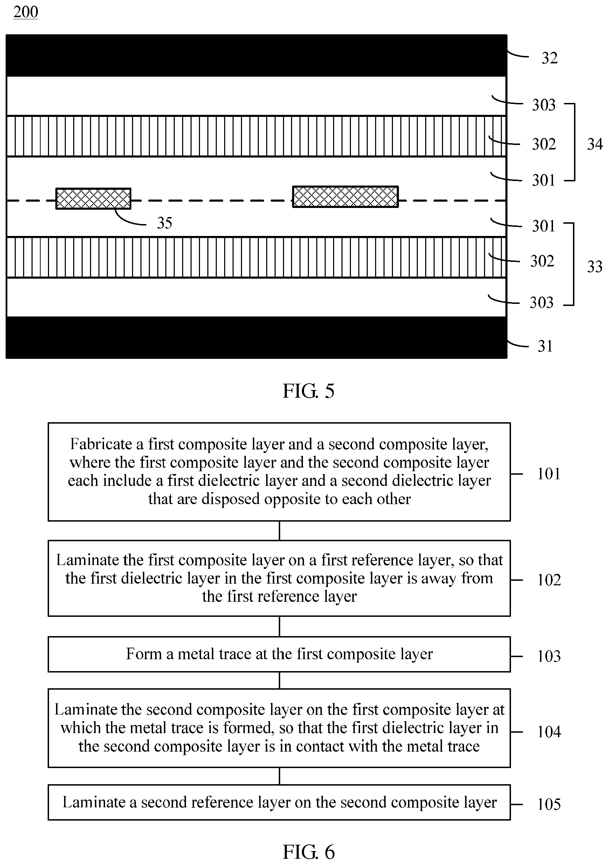

Further, based on the package substrate 200 shown in FIG. 4, as shown in FIG. 5, the first composite layer 33 and the second composite layer 34 each further include: a third dielectric layer 303 disposed on a side that is of the second dielectric layer 302 and away from the first dielectric layer 301, where a mechanical property of a material for fabricating the third dielectric layer 303 is the same as a mechanical property of a material for fabricating the first dielectric layer 301.

For example, a coefficient of thermal expansion of the material for fabricating the third dielectric layer 303 is the same as a coefficient of thermal expansion of the material for fabricating the first dielectric layer 301.

Optionally, the material of the third dielectric layer 303 may be the same as the material of the first dielectric layer 301.

In this case, the first composite layer 33 and the second composite layer 34 each can be regarded as a "sandwich structure" in which the first dielectric layer 301 and the third dielectric layer 303 sandwich the second dielectric layer 302. A reason for respectively disposing the first dielectric layer 301 and the third dielectric layer 303 with the same material on two sides of the second dielectric layer 302 is as follows: The stiffness of the second dielectric layer 302 is greater than the stiffness of the first dielectric layer 301, and when the second dielectric layer 302 is directly laminated with the first dielectric layer 301 to form the first composite layer 33 or the second composite layer 34, the first dielectric layer 301 with relatively small stiffness may be deformed. In this case, an unstable material structure in the first composite layer 33 or the second composite layer 34 leads to deformation of the first composite layer 33 or the second composite layer 34, and this increases difficulty of a technique for fabricating the first composite layer 33 and the second composite layer 34. However, when the first dielectric layer 301 and the third dielectric layer 303 with the same material are respectively disposed on the two sides of the second dielectric layer 302 for lamination, tension is generated on both a contact surface between the first dielectric layer 301 and the second dielectric layer 302 and a contact surface between the third dielectric layer 303 and the second dielectric layer 302. In this way, the first dielectric layer 301 and the third dielectric layer 303 are attached on the two sides of the second dielectric layer 302, so that a structurally stable "sandwich structure" is formed in each of the first composite layer 33 and the second composite layer 34, and more stable structures of the first composite layer 33 and the second composite layer 34 are formed.

Optionally, a thickness of the third dielectric layer 303 is equal to a thickness of the first dielectric layer 301.

For example, a coefficient of thermal expansion (Coefficient of Thermal Expansion, CTE) of the second dielectric layer 302 may be less than or equal to 9 ppm/°C.

For example, a Young's modulus of the second dielectric layer 302 may be greater than or equal to 25 MPa.

For example, the dielectric loss factor of the first dielectric layer 301 may be less than or equal to 0.01.

For example, the material for fabricating the first dielectric layer 301 and the third dielectric layer 303 may be a material, such as epoxy resin base, featuring high frequency and a low loss.

For example, a material for fabricating the second dielectric layer 302 may be a mixed material of a bismaleimide-triazine resin material and fiber glass cloth.

For example, the first reference layer 31 and the second reference layer 32 may be conductive metal plates.

Certainly, the foregoing is merely an example of a material selected for each component in the package substrate 200 provided in this embodiment of the present invention. A person skilled in the art may perform selection according to practical experience or an actual requirement. This is not limited in this embodiment of the present invention.

In addition, the package substrate 200 shown in FIG. 4 or FIG. 5 is described by using only the first reference layer 31, the second reference layer 32, and the composite layers (that is, the first composite layer 33 and the second composite layer 34) between the two reference layers as an example. It should be understood that the package substrate 200 may be formed by multiple reference layers and multiple composite layers that are stacked alternately, and a structure of the first composite layer 33 and the second composite layer 34 shown in FIG. 4 or FIG. 5 may be disposed between any two reference layers.

Further, based on the package substrate 200 shown in FIG. 4 or FIG. 5, an embodiment of the present invention provides a method for fabricating a package substrate. As shown in FIG. 6, the method includes the following steps.

101. Fabricate a first composite layer and a second composite layer, where the first composite layer and the second composite layer each include a first dielectric layer and a second dielectric layer that are disposed opposite to each other.

Stiffness of the second dielectric layer is greater than stiffness of the first dielectric layer.

Specifically, as shown in FIG. 4, the first dielectric layer 301 and the second dielectric layer 302 may be laminated by using a lamination technique to form the first composite layer 33 or the second composite layer 34.

In addition, as shown in FIG. 5, the first composite layer 33 and the second composite layer 34 each may further include: a third dielectric layer 303 disposed on a side that is of the second dielectric layer 302 and away from the first dielectric layer 301. A material of the third dielectric layer 303 is the same as a material of the first dielectric layer 301, and a thickness of the third dielectric layer 303 is equal to a thickness of the first dielectric layer 301. That is, the first dielectric layer 301, the second dielectric layer 302, and the third dielectric layer 303 form a "sandwich structure".

In this case, during fabrication of the first composite layer 33 or the second composite layer 34, the second dielectric layer 302 may be used as an intermediate layer, and the first dielectric layer 301 and the third dielectric layer 303 are directly laminated onto two sides of the second dielectric layer 302 respectively.

102. Laminate the first composite layer on a first reference layer, so that the first dielectric layer in the first composite layer is away from the first reference layer.

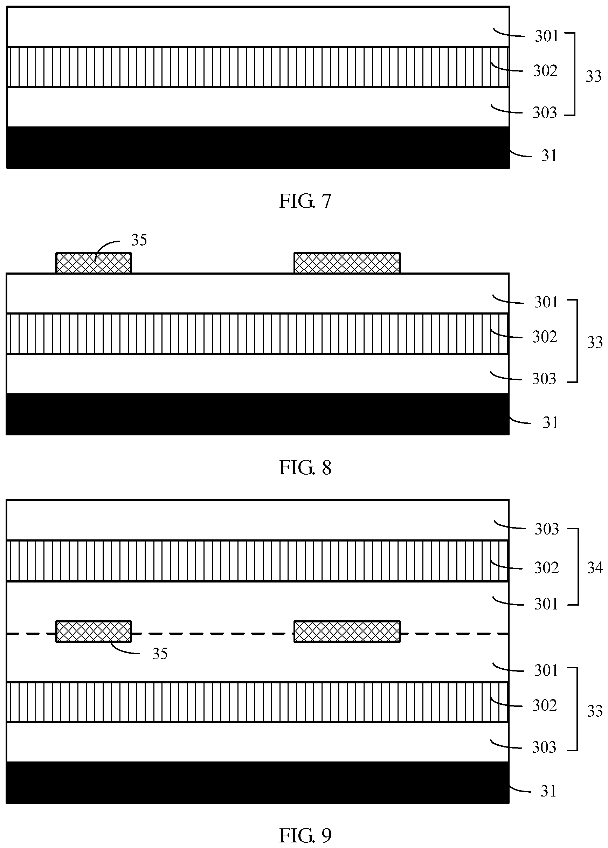

Specifically, as shown in FIG. 7, the first composite layer 33 may be laminated onto the first reference layer 31 by using the third dielectric layer 303 in the first composite layer 33 as a lamination surface, so that the first dielectric layer 301 in the first composite layer 33 is away from the first reference layer 31.

A thickness of the second dielectric layer 302 may be set according to a width of a metal trace 35, so that impedance is consistent before and after the width of the metal trace 35 is changed. The width of the metal trace 35 may be set according to a speed or frequency of a signal that needs to be transmitted. When a speed or frequency of a transmitted signal is higher, the width of the metal trace 35 may be increased to reduce a conductor loss generated during signal transmission. Correspondingly, the thickness of the second dielectric layer 302 may be increased.

103. Form a metal trace at the first composite layer.

Specifically, as shown in FIG. 8, the metal trace 35 is formed at the first dielectric layer 301 in the first composite layer 33. The width of the metal trace 35 may also be set according to a speed or frequency of a signal.

104. Laminate the second composite layer on the first composite layer at which the metal trace is formed, so that the first dielectric layer in the second composite layer is in contact with the metal trace.

Specifically, as shown in FIG. 9, the second composite layer 34 may be laminated, by using the first dielectric layer 301 in the second composite layer 34 as a lamination surface, onto the first composite layer 33 at which the metal trace 35 is formed. In this case, the metal trace 35 is enclosed by the first dielectric layers 301 in the first composite layer 33 and the second composite layer 34.

105. Laminate a second reference layer on the second composite layer.

Finally, the second reference layer 32 is laminated on the third dielectric layer 303 in the second composite layer 34 to form the package substrate 200 shown in FIG. 5.

Alternatively, based on the package substrate 200 shown in FIG. 4 or FIG. 5, an embodiment of the present invention provides another method for fabricating a package substrate, that is:
directly performing lamination in a sequence of the first reference layer 31, the first composite layer 33, the metal trace 35, the second composite layer 34, and the second reference layer 32 in FIG. 4 or FIG. 5, so as to form the package substrate 200 in a one-off manner.

Alternatively, based on the package substrate 200 shown in FIG. 4 or FIG. 5, an embodiment of the present invention provides another method for fabricating a package substrate. Using the package substrate 200 shown in FIG. 4 as an example, the fabrication method includes:
laminating a second dielectric layer 302 of a first composite layer 33 on a first reference layer 31;
laminating a first dielectric layer 301 of the first composite layer 33 on the second dielectric layer 302, where in this case, the first dielectric layer 301 and the second dielectric layer 302 constitute the first composite layer 33;
laminating a metal trace 35 on the first dielectric layer 301 of the first composite layer 33;
laminating another first dielectric layer 301, that is, a first dielectric layer 301 of a second composite layer 34, on the first dielectric layer 301 of the first composite layer 33;
laminating another second dielectric layer 302, that is, a second dielectric layer 302 of the second composite layer 34, on the first dielectric layer 301 of the second composite layer 34, where in this case, the first dielectric layer 301 and the second dielectric layer 302 above the metal trace 35 constitute the second composite layer 34; and
finally laminating a second reference layer 32 on the second dielectric layer 302 of the second composite layer 34 to form the package substrate 200.

Further, an embodiment of the present invention further provides an integrated circuit chip, and the integrated circuit chip includes any one of the foregoing package substrates 200.

Further, an embodiment of the present invention further provides a printed circuit board, and the printed circuit board includes any one of the foregoing package substrates 200.

Till now, the embodiments of the present invention provide a package substrate and a fabrication method thereof, an integrated circuit chip, and a printed circuit board. The package substrate includes a first reference layer and a second reference layer that are disposed opposite to each other, a first composite layer is disposed on a side that is of the first reference layer and close to the second reference layer, a second composite layer is disposed on a side that is of the second reference layer and close to the first reference layer, and a metal trace is laminated between the first composite layer and the second composite layer. Specifically, the first composite layer and the second composite layer each include a first dielectric layer and a second dielectric layer that are disposed opposite to each other. In the first composite layer and the second composite layer, the first dielectric layer is in contact with the metal trace. Stiffness of the second dielectric layer is greater than stiffness of the first dielectric layer. It can be learned that in both composite layers, the first dielectric layer with relatively small stiffness is in contact with the metal trace, so that the metal trace is enclosed by the first dielectric layers by using a lamination technique. The second dielectric layer with relatively large stiffness is disposed on a side that is of the first dielectric layer and away from the metal trace. That is, the second dielectric layer is not easy to deform. Therefore, a second dielectric layer with a relatively large thickness can be produced. In this case, for a high frequency signal or a high-speed signal, to reduce a conductor loss generated during signal transmission as much as possible, a thickness of the second dielectric layer may be increased in addition to increasing a width of the metal trace. This further reduces a link loss throughout the transmission.

A person skilled in the art should be aware that in the foregoing one or more examples, functions described in the present invention may be implemented by hardware, software, firmware, or any combination thereof. When the present invention is implemented by software, the foregoing functions may be stored in a computer-readable medium or transmitted as one or more instructions or code in the computer-readable medium. The computer-readable medium includes a computer storage medium and a communications medium, where the communications medium includes any medium that enables a computer program to be transmitted from one place to another. The storage medium may be any available medium accessible to a general-purpose or dedicated computer.

The objectives, technical solutions, and benefits of the present invention are further described in detail in the foregoing specific embodiments. It should be understood that the foregoing descriptions are merely specific embodiments of the present invention, but are not intended to limit the protection scope of the present invention. Any modification, equivalent replacement, or improvement made within the principle of the present invention shall fall within the protection scope of the present invention.

## Claims

1. A package substrate, wherein the package substrate comprises a first reference layer (31) and a second reference layer (32) that are disposed opposite to each other;
a first composite layer (33) is disposed on a side that is of the first reference layer (31) and close to the second reference layer (32), a second composite layer (34) is disposed on a side that is of the second reference layer (32) and close to the first reference layer (31), and a metal trace (35) is laminated between the first composite layer (33) and the second composite layer (34); and
the first composite layer (33) and the second composite layer (34) each comprise a first dielectric layer (301) and a second dielectric layer (302) that are disposed opposite to and in contact with each other, the first dielectric layer (301) is in contact with the metal trace (35), and stiffness of the second dielectric layer (302) is greater than stiffness of the first dielectric layer (301),
**characterized in that**, a dielectric loss factor of the first dielectric layer (301) is less than a dielectric loss factor of the second dielectric layer (302).

2. The package substrate according to claim 1, wherein the first composite layer (33) and the second composite layer (34) each further comprise: a third dielectric layer (303) disposed on a side that is of the second dielectric layer (302) and away from the first dielectric layer (301), wherein
a mechanical property of a material of the third dielectric layer (303) is the same as a mechanical property of a material of the first dielectric layer (301).

3. The package substrate according to claim 2, wherein the material of the third dielectric layer (303) is the same as the material of the first dielectric layer (301), and a thickness of the third dielectric layer (303) is equal to a thickness of the first dielectric layer (301).

4. The package substrate according to any one of claims 1 to 3, wherein a coefficient of thermal expansion of the second dielectric layer (302) is less than or equal to 9 ppm/°C.

5. The package substrate according to any one of claims 1 to 4, wherein a Young's modulus of the second dielectric layer (302) is greater than or equal to 25 MPa.

6. A method for fabricating a package substrate, comprising:
laminating (102) a first composite layer on a first reference layer, wherein the first composite layer comprises a first dielectric layer and a second dielectric layer that are disposed opposite to each other, stiffness of the second dielectric layer is greater than stiffness of the first dielectric layer, and the first dielectric layer in the first composite layer is away from the first reference layer;
forming (103) a metal trace at the first composite layer;
laminating (104) a second composite layer on the first composite layer at which the metal trace is formed, wherein the second composite layer comprises a first dielectric layer and a second dielectric layer that are disposed opposite to each other, stiffness of the second dielectric layer is greater than stiffness of the first dielectric layer, and the first dielectric layer in the second composite layer is in contact with the metal trace, and a dielectric loss factor of the first dielectric layer is less than a dielectric loss factor of the second dielectric layer; and
laminating (105) a second reference layer on the second composite layer.

7. The fabrication method according to claim 6, before the laminating (102) a first composite layer on a first reference layer, further comprising:
fabricating (101) the first composite layer and the second composite layer.

8. The fabrication method according to claim 7, wherein the first composite layer and the second composite layer each further comprise: a third dielectric layer disposed on a side that is of the second dielectric layer and away from the first dielectric layer, and a material of the third dielectric layer is the same as a material of the first dielectric layer, wherein
fabricating (101) the first composite layer or the second composite layer comprises:
respectively laminating the first dielectric layer and the third dielectric layer onto two sides of the second dielectric layer to obtain the first composite layer or the second composite layer.

9. The fabrication method according to claim 8, wherein:
the laminating (102) a first composite layer on a first reference layer comprises:
laminating the first composite layer onto the first reference layer by using the third dielectric layer in the first composite layer as a lamination surface; and
the laminating (104) a second composite layer on the first composite layer at which the metal trace is formed comprises:
laminating, by using the first dielectric layer in the second composite layer as a lamination surface, the second composite layer onto the first composite layer at which the metal trace is formed.

10. An integrated circuit chip, wherein the integrated circuit chip comprises the package substrate according to any one of claims 1 to 5.

## Patentansprüche

1. Paketsubstrat, wobei das Paketsubstrat eine erste Referenzschicht (31) und eine zweite Referenzschicht (32) umfasst, die einander gegenüberliegend angeordnet sind;
eine erste Verbundschicht (33) auf einer Seite, die zu der ersten Referenzschicht (31) gehört, und nahe der zweiten Referenzschicht (32) angeordnet ist, eine zweite Verbundschicht (34) auf einer Seite, die zu der zweiten Referenzschicht (32) gehört, und nahe der ersten Referenzschicht (31) angeordnet ist, und eine Metallleiterbahn (35) zwischen der ersten Verbundschicht (33) und der zweiten Verbundschicht (34) laminiert ist; und
die erste Verbundschicht (33) und die zweite Verbundschicht (34) jeweils eine erste dielektrische Schicht (301) und eine zweite dielektrische Schicht (302) umfassen, die einander gegenüberliegend und in Kontakt miteinander angeordnet sind, wobei die erste dielektrische Schicht (301) in Kontakt mit der Metallleiterbahn (35) ist, und die Steifigkeit der zweiten dielektrischen Schicht (302) größer ist als die Steifigkeit der ersten dielektrischen Schicht (301),
**dadurch gekennzeichnet, dass** ein dielektrischer Verlustfaktor der ersten dielektrischen Schicht (301) kleiner ist als ein dielektrischer Verlustfaktor der zweiten dielektrischen Schicht (302).

2. Paketsubstrat gemäß Anspruch 1, wobei die erste Verbundschicht (33) und die zweite Verbundschicht (34) ferner jeweils umfassen: eine dritte dielektrische Schicht (303), die auf einer Seite, die zu der zweiten dielektrischen Schicht (302) gehört, und von der ersten dielektrischen Schicht (301) entfernt angeordnet ist, wobei eine mechanische Eigenschaft eines Materials der dritten dielektrischen Schicht (303) dieselbe ist wie eine mechanische Eigenschaft eines Materials der ersten dielektrischen Schicht (301).

3. Paketsubstrat gemäß Anspruch 2, wobei das Material der dritten dielektrischen Schicht (303) dasselbe ist wie das Material der ersten dielektrischen Schicht (301) und eine Dicke der dritten dielektrischen Schicht (303) gleich einer Dicke der ersten dielektrischen Schicht (301) ist.

4. Paketsubstrat gemäß einem der Ansprüche 1 bis 3, wobei ein Koeffizient der thermischen Ausdehnung der zweiten dielektrischen Schicht (302) kleiner oder gleich 9 ppm/°C ist.

5. Paketsubstrat gemäß einem der Ansprüche 1 bis 4, wobei ein Youngsches Modul der zweiten dielektrischen Schicht (302) größer oder gleich 25 MPa ist.

6. Verfahren zum Fertigen eines Paketsubstrats, umfassend:
Laminieren (102) einer ersten Verbundschicht auf einer ersten Referenzschicht, wobei die erste Verbundschicht eine erste dielektrische Schicht und eine zweite dielektrische Schicht umfasst, die einander gegenüberliegend angeordnet sind, die Steifigkeit der zweiten dielektrischen Schicht größer ist als die Steifigkeit der ersten dielektrischen Schicht und die erste dielektrische Schicht in der ersten Verbundschicht von der ersten Referenzschicht entfernt ist;
Bilden (103) einer Metallleiterbahn an der ersten Verbundschicht;
Laminieren (104) einer zweiten Verbundschicht auf der ersten Verbundschicht, an welcher die Metallleiterbahn gebildet ist, wobei die zweite Verbundschicht eine erste dielektrische Schicht und eine zweite dielektrische Schicht umfasst, die einander gegenüberliegend angeordnet sind, die Steifigkeit der zweiten dielektrischen Schicht größer ist als die Steifigkeit der ersten dielektrischen Schicht und die erste dielektrische Schicht in der zweiten Verbundschicht in Kontakt mit der Metallleiterbahn ist und ein dielektrischer Verlustfaktor der ersten dielektrischen Schicht kleiner ist als ein dielektrischer Verlustfaktor der zweiten dielektrischen Schicht; und
Laminieren (105) einer zweiten Referenzschicht auf der zweiten Verbundschicht.

7. Fertigungsverfahren gemäß Anspruch 6, vor dem Laminieren (102) einer ersten Verbundschicht auf einer ersten Referenzschicht ferner umfassend:
Fertigen (101) der ersten Verbundschicht und der zweiten Verbundschicht.

8. Fertigungsverfahren gemäß Anspruch 7, wobei die erste Verbundschicht und die zweite Verbundschicht ferner jeweils umfassen: eine dritte dielektrische Schicht, die auf einer Seite, die zu der zweiten dielektrischen Schicht gehört, und von der ersten dielektrischen Schicht entfernt angeordnet ist und wobei ein Material der dritten dielektrischen Schicht dasselbe ist wie ein Material der ersten dielektrischen Schicht, wobei
das Fertigen (101) der ersten Verbundschicht oder der zweiten Verbundschicht umfasst:
jeweiliges Auflaminieren der ersten dielektrischen Schicht und der dritten dielektrischen Schicht auf zwei Seiten der zweiten dielektrischen Schicht, um die erste Verbundschicht oder die zweite Verbundschicht zu erhalten.

9. Fertigungsverfahren gemäß Anspruch 8, wobei:
das Laminieren (102) einer ersten Verbundschicht auf einer ersten Referenzschicht umfasst:
Auflaminieren der ersten Verbundschicht auf die erste Referenzschicht durch Verwenden der dritten dielektrischen Schicht in der ersten Verbundschicht als Laminationsfläche; und
das Laminieren (104) einer zweiten Verbundschicht auf der ersten Verbundschicht, an welcher die Metallleiterbahn gebildet ist, umfasst:
Auflaminieren, durch Verwenden der ersten dielektrischen Schicht in der zweiten Verbundschicht als Laminationsfläche, der zweiten Verbundschicht auf die erste Verbundschicht, an welcher die Metallleiterbahn gebildet ist.

10. Integrierter Schaltungschip, wobei der integrierte Schaltungschip das Paketsubstrat gemäß einem der Ansprüche 1 bis 5 umfasst.

## Revendications

1. Substrat de boîtier, dans lequel le substrat de boîtier comprend une première couche de référence (31) et une seconde couche de référence (32) qui sont disposées en face l'une de l'autre ;
une première couche composite (33) est disposée sur un côté qui est de la première couche de référence (31) et près de la seconde couche de référence (32), une seconde couche composite (34) est disposée sur un côté qui est de la seconde couche de référence (32) et près de la première couche de référence (31), et une trace de métal (35) est stratifiée entre la première couche composite (33) et la seconde couche composite (34) ; et
la première couche composite (33) et la seconde couche composite (34) comprennent chacune une première couche diélectrique (301) et une deuxième couche diélectrique (302) qui sont disposées en face l'une de l'autre et en contact l'une avec l'autre, la première couche diélectrique (301) est en contact avec la trace de métal (35), et la raideur de la deuxième couche diélectrique (302) est supérieure à la raideur de la première couche diélectrique (301),
**caractérisé en ce qu'**un facteur de perte diélectrique de la première couche diélectrique (301) est inférieur à un facteur de perte diélectrique de la deuxième couche diélectrique (302).

2. Substrat de boîtier selon la revendication 1, dans lequel la première couche composite (33) et la seconde couche composite (34) comprennent en outre chacune :
une troisième couche diélectrique (303) disposée sur un côté qui est de la deuxième couche diélectrique (302) et éloigné de la première couche diélectrique (301), dans lequel
une propriété mécanique d'un matériau de la troisième couche diélectrique (303) est la même qu'une propriété mécanique d'un matériau de la première couche diélectrique (301).

3. Substrat de boîtier selon la revendication 2, dans lequel le matériau de la troisième couche diélectrique (303) est le même que le matériau de la première couche diélectrique (301), et une épaisseur de la troisième couche diélectrique (303) est égale à une épaisseur de la première couche diélectrique (301).

4. Substrat de boîtier selon l'une quelconque des revendications 1 à 3, dans lequel un coefficient de dilatation thermique de la deuxième couche diélectrique (302) est inférieur ou égal à 9 ppm/°C.

5. Substrat de boîtier selon l'une quelconque des revendications 1 à 4, dans lequel un module de Young de la deuxième couche diélectrique (302) est supérieur ou égal à 25 MPa.

6. Procédé pour fabriquer un substrat de boîtier, comprenant :
la stratification (102) d'une première couche composite sur une première couche de référence, dans lequel la première couche composite comprend une première couche diélectrique et une deuxième couche diélectrique qui sont disposées en face l'une de l'autre, la raideur de la deuxième couche diélectrique est supérieure à la raideur de la première couche diélectrique, et la première couche diélectrique dans la première couche composite est éloignée de la première couche de référence ;
la formation (103) d'une trace de métal au niveau de la première couche composite ;
la stratification (104) d'une seconde couche composite sur la première couche composite au niveau de laquelle la trace de métal est formée, dans lequel la seconde couche composite comprend une première couche diélectrique et une deuxième couche diélectrique qui sont disposées en face l'une de l'autre, la raideur de la deuxième couche diélectrique est supérieure à la raideur de la première couche diélectrique, et la première couche diélectrique dans la seconde couche composite est en contact avec la trace de métal, et un facteur de perte diélectrique de la première couche diélectrique est inférieur à un facteur de perte diélectrique de la deuxième couche diélectrique ; et
la stratification (105) d'une seconde couche de référence sur la seconde couche composite.

7. Procédé de fabrication selon la revendication 6, avant la stratification (102) d'une première couche composite sur une première couche de référence, comprenant en outre :
la fabrication (101) de la première couche composite et de la seconde couche composite.

8. Procédé de fabrication selon la revendication 7, dans lequel la première couche composite et la seconde couche composite comprennent en outre chacune : une troisième couche diélectrique disposée sur un côté qui est de la deuxième couche diélectrique et éloigné de la première couche diélectrique, et un matériau de la troisième couche diélectrique est le même qu'un matériau de la première couche diélectrique, dans lequel
la fabrication (101) de la première couche composite ou de la seconde couche composite comprend :
respectivement la stratification de la première couche diélectrique et de la troisième couche diélectrique sur deux côtés de la deuxième couche diélectrique pour obtenir la première couche composite ou la seconde couche composite.

9. Procédé de fabrication selon la revendication 8, dans lequel :
la stratification (102) d'une première couche composite sur une première couche de référence comprend :
la stratification de la première couche composite sur la première couche de référence en utilisant la troisième couche diélectrique dans la première couche composite en tant que surface de stratification ; et
la stratification (104) d'une seconde couche composite sur la première couche composite au niveau de laquelle la trace de métal est formée comprend :
la stratification, en utilisant la première couche diélectrique dans la seconde couche composite en tant que surface de stratification, de la seconde couche composite sur la première couche composite au niveau de laquelle la trace de métal est formée.

10. Puce à circuit intégré, dans lequel la puce à circuit intégré comprend le substrat de boîtier selon l'une quelconque des revendications 1 à 5.
